(19) Europäisches Patentamt
European Patent Office
Office européen des brevets

(11) **EP 4 300 118 A1**

(12) **EUROPÄISCHE PATENTANMELDUNG**

(43) Veröffentlichungstag:
**03.01.2024  Patentblatt 2024/01**

(51) Internationale Patentklassifikation (IPC):
**G01R 33/34** (2006.01)

(21) Anmeldenummer: 23182252.9

(22) Anmeldetag: **29.06.2023**

(52) Gemeinsame Patentklassifikation (CPC):
**G01R 33/34053; G01R 33/34092**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(30) Priorität: **01.07.2022  DE 102022206768**

(71) Anmelder: **Bruker Switzerland AG
8117 Fällanden (CH)**

(72) Erfinder: **Freytag, Nicolas
8122 Binz (CH)**

(74) Vertreter: **Kohler Schmid Möbus Patentanwälte
Partnerschaftsgesellschaft mbB
Gropiusplatz 10
70563 Stuttgart (DE)**

(54) **SENDE-EMPFANGSSPULENANORDNUNG FÜR EINEN MAS-NMR-PROBENKOPF UND VERFAHREN ZUR AUSLEGUNG EINER SENDE-EMPFANGSSPULENANORDNUNG**

(57)    Die Erfindung betrifft eine Sende-Empfangsspulenanordnung für einen MAS-NMR-Probenkopf mit einer ersten Sende-Empfangsspule 1a mit einer Längs-achse Z' zur Erzeugung eines ersten HF-Magnetfeldes B1, wobei die erste Sende-Empfangsspule 1a zumindest einen solenoidförmigen Abschnitt, der einen elektrischen Leiter aufweist mit einer Leiterbahnbreite W und $N \geq 3$ Windungen, wobei alle Windungen um die Längsachse Z' der Sende-Empfangsspule 1 verlaufen, wobei der elektrische Leiter eine Steigung S aufweist und jede Halbwindung mit einer Neigung T gegenüber der Längsachse Z' geneigt ist, wobei für zumindest einen Teil der Halbwindungen $T \neq 0$ gilt. Erfindungsgemäß ändern sich mindestens zwei der folgenden Größen über den Verlauf t der Länge des elektrischen Leiters der Sende-Emp-fangsspule 1a: Neigung $T = T(t)$, Steigung $S = S(t)$, Lei-terbahnbreite $W = W(t)$. Hierdurch kann die Sende-Emp-fangsspule derart optimiert werden, dass der Homogen-bereich in axialer und in radialer Richtung innerhalb des Field of View verbessert und/oder die Stärke des von der Sende-Empfangsspule erzeugten HF-Magnetfelds B1 bei gegebener Leistung erhöht wird.

**Fig. 1**

**Beschreibung**

Hintergrund der Erfindung

Die Erfindung betrifft eine Sende-Empfangsspulenanordnung für einen MAS-NMR-Probenkopf mit einer ersten Sende-Empfangsspule mit einer Längsachse Z' zur Erzeugung eines ersten HF-Magnetfeldes B1, wobei die erste Sende-Empfangsspule zumindest einen solenoidförmigen Abschnitt, der einen elektrischen Leiter aufweist mit einer Leiterbahnbreite W und N ≥ 3 Windungen, wobei alle Windungen um die Längsachse Z' der Sende-Empfangsspule verlaufen, wobei der elektrische Leiter eine Steigung S aufweist und jede Halbwindung mit einer Neigung T gegenüber der Längsachse Z' geneigt ist, wobei für zumindest einen Teil der Halbwindungen T ≠ 0 gilt. Die Erfindung betrifft auch ein Verfahren zur Auslegung einer Sende-Empfangsspulenanordnung.

Eine Sende-Empfangsspulenanordnung mit geneigten Windungen für einen MAS-NMR-Probenkopf ist bekannt aus [Sun et. al.] und [Barbara et al.].

In einem MAS-Probenkopf steht die Sende-Empfangsspulenanordnung typischerweise im magischen Winkel von 54,7° zum statischen Magnetfeld B0 (Hauptfeldmagnet).

Aus [Sun et. al.] und [Barbara et al.] ist bekannt, dass solenoidförmige Sende-Empfangsspulen für NMR-MAS Probenköpfe mit einem Neigungswinkel gegenüber der Achse der Solenoidspule ausgeführt sind, sodass das durch die Solenoidspule entstehende hochfrequente B1 Feld möglichst senkrecht zum statischen B0 Feld steht.

In [Sun et al.] wird versucht durch Verwendung eines Neigungswinkels $\psi = 90 - \varphi_{MAS}$ die Empfindlichkeit einer NMR-Spule zu steigern. Dabei erreichen sie bis zu 17% kürzere Pulswinkel bei gleicher gesendeter Leistung für eine MAS-Anordnung. In [Sun et al.] wird davon ausgegangen, dass die erzeugten B1-Felder räumlich konstante Winkel erzeugen und unabhängig von der konkreten Implementierung der Spule mit ausgedehntem Leiterquerschnitt sind. Off-axis Effekte im Randbereich der Spulen werden in [Sun et . al.] nicht untersucht.

In [Barbara et al.] wird versucht durch die Gestaltung einer komplexeren Spulengeometrie eine Lösung für die erzeugten HF-Magnetfelder B1 zu finden, bei der letztere im gesamten aktiven Bereich der Spule in der XY-Ebene zu liegen kommen. Zielfunktion der Optimierung in [Barbara et al.] ist also die Absenz von z-Komponenten des erzeugten B1-Feldes in einem zylinderförmigen Messvolumen. Dabei werden insbesondere Geometrien vorgeschlagen, die von einer Solenoidform abweichen mit Windungen, die nicht um die Längsachse der Spule verlaufen. Die in [Barbara et al.] gezeigte Spulengeometrie soll in Kombination mit einer zweiten Spule/Resonator eingesetzt werden, wobei das durch die zweite Spule erzeugte HF-Magnetfeld keine Bz-Komponenten aufweisen soll. In [Barbara et al.] wird davon ausgegangen, dass ein NMR-Messkopf mit Spulen, die ein HF-Magnetfeld mit B = Bxy erzeugen, auch bei Verwendung in einem Messkopf mit mehr als einer Sende-Empfangsspulenanordnung, i.e. auch für Kreuzpolarisationsmessungen, die maximale Empfindlichkeit aufweisen. Abschirmeffekte durch Leiter der Spule werden nicht berücksichtigt.

Die Lösungen von [Sun et al.] und [Barbara et al.] gehen von einer verschwindenden Leiterbahnbreite aus (nicht ausgedehnter Leiter) und stellen für endliche Leiterbahnbreiten, insbesondere jedoch sehr geringe Abstände zwischen den Leiterbahnen nicht die beste Lösung dar.

Neben Spulengeometrien basierend auf Leitern mit rundem oder ovalem Querschnitt ist es auch bekannt, bandförmige Leiter für NMR-Probenköpfe zu verwenden. Insbesondere können solche Spulengeometrien auf einem zylindermantelförmigen Leiter strukturiert (z.B. indem eine metallische Schicht auf einem Träger mit zylindrischer Oberfläche strukturiert aufgebacht wird oder ein gleichförmig aufgebrachter Leiter durch subtraktive Herstellungsverfahren strukturiert wird) oder aus einem Zylindermantelförmigen Leiter ausgeschnitten wird. Diese Herstellungsverfahren ermöglichen eine größere Freiheit in der Gestaltung der Spulengeometrie, insbesondere einer variablen Steigung.

[Privalov et al.] beschreibt Sende-Empfangsspulen mit einem bandförmigen Leiter. Zur Optimierung der axialen Homogenität wird die Leiterbahnbreite zu den axialen Enden hin verringert. Zur Minimierung der radialen Inhomogenität wird der Leiterabstand zwischen den Windungen möglichst klein und konstant gehalten. Die Effizienz dieser Sende-Empfangsspule ist jedoch nicht optimal.

Aufgabe der Erfindung

Es ist Aufgabe der Erfindung, eine Sende-Empfangsspule für NMR-MAS Anwendungen derart zu optimieren, dass der Homogenbereich in axialer und in radialer Richtung innerhalb des Field of View (Bereich innerhalb der Sende-Empfangsspule, in dem eine zu untersuchende Probe positioniert und mittels NMR untersucht werden kann) verbessert und/oder die Stärke des von der Sende-Empfangsspule erzeugten HF-Magnetfelds B1 bei gegebener Leistung erhöht wird.

Beschreibung der Erfindung

Diese Aufgabe wird erfindungsgemäß gelöst durch eine Sende-Empfangsspulenanordnung gemäß Anspruch 1 und einem Verfahren gemäß Anspruch 8.

Erfindungsgemäß ändern sich mindestens zwei der folgenden Größen über den Verlauf t der Länge des elektrischen Leiters der Sende-Empfangsspule: Steigung S = S(t), Neigung T = T(t), Leiterbahnbreite W = W(t).

Eine Änderung der **Steigung** S= S(t) kann realisiert werden durch eine Änderung der Ganghöhe P (Steigung einer Windung), aber auch bereits durch eine Änderung der lokalen Steigung S innerhalb einer Windung bei konstantem P.

Die **Ganghöhe P(n)** («pitch») der n-ten Windung ist definiert als $P(t) = \int_{tn}^{tn+1} S(t)\, \mathrm{d}t$ die lokale Steigung S(t) der Windungen (i.e. der Strecke, die über eine Windung in Z'-Richtung zurücklegt wird), wobei S(t) die lokale Steigung ist, wobei tn der Laufparameter t des Leiterverlaufs am Anfang der n-ten Windung ist, d.h. tn = 0, 1, ....

Bei konstanter Ganghöhe P kann die lokale Steigung S innerhalb einer Windung variieren und dabei sogar das Vorzeichen kehren. Die Ganghöhe P einer Windung soll als positiv bezeichnet werden, wenn die Z'-Koordinate der Mittellinien für tn+1 größer ist als die Z'-Koordinate bei tn. Dies gilt selbst dann, wenn die Z'-Koordinate im Intervall zwischen tn und tn+1 kleinere Werte annimmt als bei tn. Die Steigung S der Windungen sowie die Leiterbahnbreite W bzw. das Verhältnis S/W von Steigung S und Leiterbahnbreite W haben Einfluss auf die axiale Homogenität.

Die mehreren Windungen der Sende-Empfangsspule können auch als Einzelwindungen, die induktiv oder kapazitiven gekoppelt sind, ausgeführt sein. Die Ganghöhe beschreibt dann den Abstand der Mittellinien zweier benachbarter Einzelwindungen.

Die **Neigung T** der Windungen hat Einfluss auf die B1-Amplitude (Amplitude des von der Sende-Empfangsspule erzeugten HF-Magnetfelds B1) und die radiale Homogenität. Die Neigung T ist definiert als Amplitude einer sinusförmigen Modulation der Z'-Position der Leitermittelebene über eine Windung. Bei einer Spule mit Neigung T ≠ 0 unterscheidet sich die lokale Steigung S innerhalb der ersten Windungshälfte von der in der zweiten Windungshälfte. Im Falle einer über den Verlauf t der Länge des elektrischen Leiters variierenden Neigung T = T(t) ist die Neigung vorzugsweise abschnittsweise konstant, insbesondere für mindestens eine Halbwindung (halbe Windung). Die Neigung T ändert sich dann also von Halbwindung zu Halbwindung.

Eine Spule mit Neigung T ≠ 0 kann prinzipiell auch durch eine variable Steigung S'(t) = S(t) + $T(t)\cos(2\pi t + \varphi)$ (allgemeine Steigung) beschrieben werden. Wenn S'(t) als Fourierreihe geschrieben wird, dann beschreibt T den (t = 1)-periodischen Anteil der Steigung. Für jede Windung kann die Steigung geschrieben werden als:

$$S'(t) = S_0 + \sum_{k=1}^{\infty}\left(S_{k,a}\cos(k\,2\pi\,t) + S_{k,b}\sin(k\,2\pi\,t)\right),$$

wobei

$$S(t) = S'(t) - \left(S_{1,a}\cos(2\pi\,t) + S_{1,b}\sin(2\pi\,t)\right).$$

$(S_{1,a}\cos(2\pi t) + S_{1,b}\sin(2\pi t))$ kann als $T(t)\cos(2\pi t + \varphi)$ geschrieben werden, wobei T die Neigung und $\varphi$ die Richtung der Neigung ist (i.d.R. ist $\varphi$ = 0 oder $\varphi$ = 90°).

Die **Leiterbahnbreite W** ist die Breite der Leiterbahn senkrecht zur Leitermitte. Im Falle einer über den Verlauf t der Länge des elektrischen Leiters variierenden Leiterbahnbreite W = W(t), kann die Leiterbahnbreite auch innerhalb einer Windung variieren.

Bei den Windungen der erfindungsgemäßen Sende-Empfangsspule handelt es sich um Windungen, die komplett um die Längsachse Z' der Sende-Empfangsspule herum verlaufen, also in einer Projektion senkrecht zur Längsachse Z' einen Kreis beschreiben. Besonders bevorzugt ist die Sende-Empfangsspule solenoidförmig oder die Sende-Empfangsspule umfasst ausschließlich solenoidförmige Wicklungsabschnitte (beispielsweise einen solenoidförmigen Hinwicklungsabschnitt und ein solenoidförmigen Rückwicklungsabschnitt s.u.).

Bei der erfindungsgemäßen Sende-Empfangsspule werden die Einflüsse verschiedener geometrischer Faktoren der Sende-Empfangsspule auf die Empfindlichkeit der Sende-Empfangsspule ausgenutzt. Um eine Optimierung der Spulenempfindlichkeit von Sende-Empfangsspulen mit (senkrecht zum Verlauf des Leiters) ausgedehntem Leiter zu erreichen, werden erfindungsgemäß mindestens zwei der oben genannten Parameter so gewählt, dass sie abhängig sind von einem Laufparameter t entlang des elektrischen Leiters der Sende-Empfangsspule, also entlang des Verlaufs des elektrischen Leiters variieren.

Vorzugsweise ist der elektrische Leiter der ersten Sende-Empfangsspule als bandförmiger Leiter ausgeführt. Ein bandförmiger Leiter hat eine im Verhältnis zur Leiterbahnbreite geringe Dicke (insbesondere mindestens eine Größenordnung kleiner) und weist einen im Wesentlichen rechteckigen Querschnitt auf. Der bandförmige Leiter umfasst vorzugsweise ein Substrat mit einer dünnen Metallisierung, insbesondere einer HTS-Beschichtung.

Vorzugsweise beträgt die Leiterbahndicke d der Leiterbahn (d. h. die Ausdehnung des elektrischen Leiters in radialer Richtung bezogen auf die Längsachse Z' der Sende-Empfangsspule) maximal 1 mm (vorzugsweise maximal 200 $\mu$m) und/oder ist mindestens so groß wie die doppelte Eindringtiefe des HF-Stromes in den elektrischen Leiter. Darüber hinaus ist es vorteilhaft, wenn die Leiterbahndicke d mindestens 20 $\mu$m, vorzugsweise mindestens 100 $\mu$m beträgt. Unter Eindringtiefe ist die Tiefe zu verstehen, bei der die Stromdichte auf 1/e des Wertes an der Leiteroberfläche abgefallen ist (Skin-Effekt). Sie hängt vom Material des elektrischen Leiters und der Frequenz des damit erzeugten HF-Magnetfelds ab.

Für Leiter mit einem kreisförmigen Leiterquerschnitt (Rundleiter) ist bekannt, dass die optimale Güte bei einem Verhältnis von Ganghöhe zu Leiterbahnbreite P/W von P/W $\approx$ 1.5 - 1.667 (je nach Länge/Durchmesser-Verhältnis der Solenoidspule) erreicht wird. Im Rahmen der Erfindung wurde erkannt, dass bei Sende-Empfangsspulen aus Bandleitern dieses Verhältnis davon abweichend deutlich kleiner ist, d.h. bei geringer Dicke des Bandleiters ist im Gegensatz zu einem Rundleiter der Leiterabstand zwischen zwei Windungen (Spaltbreite D) deutlich geringer als die Leiterbahnbreite. Weiterhin ist diese Spaltbreite D nicht homogen über die Gesamtlänge des Leiters: Randeffekte endlicher Solenoidspulen führen dazu, dass das magnetische Feld im Randbereich nicht mehr parallel zur Z' Achse verläuft sondern "nach außen" dreht. Dies führt dazu, dass die Spaltbreite D zwischen Windungen im Randbereich der Sende-Empfangsspule größer gewählt werden sollte als im Zentrum, d.h. das Verhältnis von Spaltbreite zu Leiterbahnbreite D/W sollte am Rand größer sein als im Zentrum. Im Gegensatz zu kreiszylinderförmigen Leitern erlaubt eine aus bandförmigen Leitern hergestellte Sende-Empfangsspule eine deutlich höhere Designflexibilität, insbesondere dann, wenn sie durch Strukturierung aus einer rohrförmigen Metallisierung hergestellt wird.

Bei einer bevorzugten Ausführungsform der erfindungsgemäßen Sende-Empfangsspule ändert sich die Steigung S über den Verlauf t der Länge des elektrischen Leiters und die Leiterbahnbreite W ändert sich innerhalb jeder Windung. Insbesondere nimmt die Leiterbahnbreite innerhalb jeder Windung mindestens einmal zu und einmal ab. Vorzugsweise variiert die Leiterbahnbreite periodisch.

Besonders bevorzugt ist eine Ausführungsform mit zwei Maxima und zwei Minima der Leiterbahnbreite pro Windung, insbesondere für Sende-Empfangsspulenanordnungen mit zwei Sende-Empfangsspulen in Kreuzspulenkonfiguration. Vorzugsweise sind die Bereiche des elektrischen Leiters mit minimalen Werten für die Leiterbahnbreite bezüglich einer Rotation um die Längsachse Z' um 180° versetzt zueinander angeordnet. Bereiche des elektrischen Leiters mit minimaler Leiterbahnbreite sind dann gegenüber den Bereichen mit maximaler Leiterbahnbreite bezüglich einer Rotation um die Längsachse Z' vorzugsweise um 90° verdreht angeordnet, also um ein Viertel einer Windung voneinander beabstandet.

Vorzugsweise variiert die Leiterbahnbreite W zwischen 0,1 mm bis 2 mm.

Weiterhin ist für den Fall einer Kombination aus erster Sende-Empfangsspule mit T $\neq$ 0, die ein HF-Magnetfeld erzeugt, das im Wesentlichen innerhalb der Messprobe in einer X'Z' Ebene eines kartesischen X', Y', Z'-Koordinatensystems liegt und einer zweiten Spule, die ein zweites HF-Magnetfeld B2 erzeugt, das in der Messprobe im Wesentlichen in einer Y'Z' Ebene liegt, eine Ausführung der ersten Sende-Empfangsspule von Vorteil, die vier Maxima und vier Minima pro Windung aufweisen, wobei die Minima in der X' und Y' Richtung und die Maxima unter 45° zwischen X' und Y' zu liegen kommen.

Bei einer speziellen Ausführungsform der erfindungsgemäßen Sende-Empfangsspulenanordnung ändert sich die Steigung S und die Neigung T des elektrischen Leiters der ersten Sende-Empfangsspule entlang des Verlaufs des elektrischen Leiters

Die Neigung T hat zwei Effekte: Zunächst wird eine Feldkomponente in der X'-Richtung erzeugt. Dies ist insbesondere dann von Vorteil, wenn die Sende-Empfangs-Spule in einem statischen Magnetfeld eingesetzt wird, das entlang einer Z-Achse orientiert ist und die Z-Achse nicht kollinear mit der Längsachse Z' der Sende-Empfangsspule ist. Für eine gegebene Sende-Empfangsspule ist die zirkular polarisierte Komponente, die sich in der gleichen Richtung wie die nukleare Präzession dreht, für die nukleare Anregung relevant (Anregungsfeld B1+), und die zirkular polarisierte Komponente, die sich entgegengesetzt zur Richtung der nuklearen Präzession dreht, ist für den Signalempfang relevant (Anregungsfeld B1-), wobei gilt: B1+ = (B1x + i B1y)/2 und B1- = B1x - i B1y)/2. D.h. es sind lediglich Feldkomponenten in der X- und Y-Ebene, also senkrecht zur Richtung des statischen Magnetfeldes für Anregung und Empfang von NMR-Signalen relevant.

Anregungsfeld B1+ und Anregungsfeld B1- können durch Einstellen der Neigung T maximiert werden. Für Sende-Empfangsspulen mit einem Verhältnis der Ganghöhe zur Leiterbahnbreite P/W $\gg$ 1, d.h. für sehr schmale/dünne Leiter, wird das Maximum für das Anregungsfeld B1+ erreicht, wenn das von der Sende-Empfangsspule erzeugte Feld in der X'Z'-Ebene zu liegen kommt. Dieses Maximum schiebt jedoch zu geringerer Neigung T, wenn ausgedehnte Leiter verwendet werden, d.h. wenn die Leiterbreite W vergrößert wird, da Abschirmströme auf den Leitern die Effizienz der Sende-Empfangsspule reduzieren.

Wie oben erwähnt wurde im Rahmen der Erfindung erkannt, dass die Orientierung des B1-Feldes wie im Randbereich einer endlichen Sende-Empfangsspule ungleich der Orientierung im Zentrum ist. Nimmt die Längsachse Z' der Sende-Empfangsspule nun gegenüber der Z-Achse einen Winkel ungleich 0° oder 90° ein, dann ist B1+ oberhalb der Längsachse Z' (i.e. für X'>0) ungleich B1+ unterhalb der Längsachse Z' (i.e. für X'<0). Durch Anpassen der Neigung T im Randbereich kann B1+ im Randbereich über das komplette Samplevolumen homogenisiert werden.

Die Variation der Neigung T entlang der Länge des Leiters erlaubt es, die Effizienz der Sende-Empfangsspule zu maximieren unter der Bedingung einer radialen Mindest-Homogenität des B1+ Feldes im Randbereich.

Vorzugsweise ist die Neigung T an den axialen Enden der ersten Sende-Empfangsspule kleiner ist als am axialen Zentrum der Sende-Empfangsspule.

Unter der Bedingung, dass die Längsachse Z' der Sende-Empfangsspule im magischen Winkel zur Z-Achse steht, wird durch eine geringere Neigung T an den axialen Enden eine Maximierung der Effizienz bei gleichzeitiger Optimierung der radialen Homogenität an den axialen Enden der Sende-Empfangsspule erreicht.

Eine spezielle Ausführungsform der erfindungsgemäßen Sende-Empfangsspulenanordnung sieht vor, dass die Sende-Empfangsspulenanordnung mindestens eine weitere Sende-Empfangsspule zur Erzeugung eines zweiten HF-Magnetfelds B2 radial außerhalb der ersten Sende-Empfangsspule umfasst, und dass die erste Sende-Empfangsspule und die weitere Sende-Empfangsspule um die gemeinsame Längsachse Z' angeordnet sind, derart, dass durch die erste Sende-Empfangsspule und die weitere Sende-Empfangsspule erzeugte HF-Magnetfelder B1, B2 senkrecht zueinander ausgerichtet sind.

Die beiden Sende-Empfangsspulen sind vorzugsweise auf verschiedene Frequenzen abgestimmt. Senkrecht aufeinander stehende HF-Magnetfelder B1, B2 bedeutet, dass das Volumenintegral des Skalarproduktes der Vektoren B1(x,y,z) und B2(x,y,z) mindestens über den Bereich des Field of View (FOV) der beiden Sende-Empfangsspulen, in dem eine Messprobe angeordnet wird, ungefähr null ist, d.h. es werden nur die HF-Magnetfelder B1, B2 innerhalb der Messprobe betrachtet. Bei einer speziellen Ausführungsform wird die Orthogonalität der beiden HF-Magnetfelder B1 und B2 durch ein Anpassnetzwerk erreicht, d.h. die unmittelbar durch die beiden Sende-Empfangsspulen erzeugten HF-Magnetfelder B1 und B2 müssen nicht exakt orthogonal zueinander sein.

Insbesondere soll die Leiterbahnbreite W des elektrischen Leiters der ersten Sende-Empfangsspule in dem Bereich, in dem die Flächennormale der ersten Sende-Empfangsspule parallel zum zweiten HF-Magnetfeld B2 steht, einen minimalen Wert aufweisen. In anderen Worten ausgedrückt, ist im Bereich der Fläche der ersten Sende-Empfangsspule, die das HF-Magnetfeld B2 durchdringen muss, um die Messprobe im Field of View anzuregen, die Leiterbahnbreite W des elektrischen Leiters der ersten Sende-Empfangsspule minimal, um einen Transparenzbereich für B2 zu schaffen.

Vorzugsweise ist die weitere Sende-Empfangsspule eine Sattelspule oder ein Resonator (z.B. ein Birdcage-Resonator, Alderman-Grant-Resonator, ...).

Bei einer weiteren speziellen Ausführungsform der erfindungsgemäßen Sende-Empfangsspulenanordnung umfasst der elektrische Leiter der ersten Sende-Empfangsspule einen Hinwicklungsabschnitt und einen Rückwicklungsabschnitt, wobei der Hinwicklungsabschnitt Hinwindungen umfasst und ausgehend von einem Anschlussbereich in einem vorgegebenen Windungssinn zu einem axialen Ende der Sende-Empfangsspule führt, wobei der Rückwicklungsabschnitt Rückwindungen umfasst und ausgehend vom axialen Ende der ersten Sende-Empfangsspule im vorgegebenen Windungssinn zum Anschlussbereich führt, wobei die Windungen des Rückwicklungsabschnitts eine Ganghöhe P mit entgegengesetztem Vorzeichen zu denen des Hinwicklungsabschnitts aufweisen, und dass Hin- und Rückwindungen des elektrischen Leiters mit Ausnahme von Überkreuzungsbereichen, in denen sich die Hin- und Rückwindungen überkreuzen, auf einer gemeinsamen Zylindermantelfläche um die Längsachse Z' angeordnet sind ("Crisscross-Geometrie").

Die Hin- und Rückwindungen befinden sich also auf demselben radialen Abstand um die Längsachse Z', d.h. es befinden sich gegenläufige Wicklungen auf einer gemeinsamen Fläche. Der Anschlussbereich dient zum Verbinden des elektrischen Spulenabschnitts mit einem Anpassnetzwerk (Matching Network) und kann Anschlüsse für mehrere elektrische Spulenabschnitte umfassen. Hinwicklungsabschnitt und Rückwicklungsabschnitt bilden einen Spulenabschnitt, der zwischen zwei Anschlüssen des Anschlussbereichs verläuft, so dass die angelegte Spannung zwischen dem Anfang der Hinwindungen und dem Ende der Rückwindungen des jeweiligen Spulenabschnitts anliegt. Um die Hinwindungen und Rückwindungen auf einer gemeinsamen Zylindermantelfläche anzuordnen, müssen sich die Hinwindungen und die Rückwindungen überkreuzen. Die Überkreuzungen werden auf einem möglichst wenig ausgedehnten Abschnitt des Umfangs (Überkreuzungsbereich) ausgeführt, wobei vorzugsweise der elektrische Leiter des Hinwicklungsabschnitts oder des Rückwicklungsabschnitts auf der Zylinderoberfläche verbleibt, wohingegen der jeweils andere elektrische Leiter in Form eines Brückenelements die ersten elektrischen Leiter überquert.

Mittels dieser speziellen Ausführungsform kann die Anordnung der Windungen und des Anschlussbereichs so gewählt werden, dass die Potentiale im Betrieb der Sende-Empfangsspule an vergleichbaren Positionen benachbarter Windungen (zum Beispiel jeweils am Anfang der Windung oder in der Mitte oder am Ende) betragsmäßig gleich oder ähnlich groß sind. Das Potential wird als ähnlich angesehen, wenn gilt U1/UN=(N/2-1) / (N/2) mit U1: Spannung über erster Windung, UN: Spannung über N Windungen. Bei einer bevorzugten Ausführungsform, bei welcher der Spulenabschnitt eine Umkehrwindung umfasst, die im Betrieb einen Punkt mit Potential 0 aufweist (der durch ein sogenanntes balanced network eingestellt wird), sind die Hinwindungen und Rückwindungen eines Spulenabschnitts mit Ausnahme der Umkehrwindung daher vorzugsweise abwechselnd angeordnet. Auf diese Weise können die für eine elektrisch leitende Probe sichtbaren elektrische Felder reduziert und gleichzeitig anderweitige Performanceeinbußen verringert

**EP 4 300 118 A1**

werden. Diese Ausführungsform ist insbesondere vorteilhaft für die Untersuchung von leitfähigen Messproben oder Messproben mit hohen dielektrischen Verlusten. Durch die erfindungsgemäße geometrische Anordnung der Leiterabschnitte auf einer gemeinsamen Zylinderoberfläche können die durch die Spulen des NMR-Probenkopfs in der Messprobe erzeugten elektrischen Felder stark minimiert werden. Elektrische Felder können sowohl beim Senden als auch beim Empfangen zu Performanceeinbußen führen, z.B. dem Heizen der Messprobe, Verlängern von Pulswinkeln bei begrenzter Sendeleistung, Reduktion des Signal-zu-Rauschverhältnisses, etc..

Es können auch mehrere Spulenabschnitte vorgesehen sein, die jeweils einen Hinwicklungsabschnitt und einen Rückwicklungsabschnitt umfassen.

Vorzugsweise ist sowohl der Hinwicklungsabschnitt als auch der Rückwicklungsabschnitt solenoidförmig ausgebildet. Die Hinwindungen und Rückwindungen sind vorzugsweise abwechselnd angeordnet.

Die Erfindung betrifft auch einen MAS-NMR-Probenkopf mit einer zuvor beschriebenen Sende-Empfangsspulenanordnung, wobei der NMR-Probenkopf dazu ausgebildet ist, in einer länglichen Bohrung eines NMR-Magneten angeordnet zu werden. Die längliche Bohrung des NMR-Magneten sowie das durch den NMR-Magneten erzeugte statische Magnetfeld B0 sind entlang einer Z-Richtung ausgerichtet. Die längliche Ausdehnung des NMR-Probenkopfgehäuses verläuft ebenfalls in Z-Richtung, so dass der NMR-Probenkopf in die Bohrung des NMR-Magneten eingeführt werden kann. Die X-Richtung ist in der X'Z' Ebene und Y = Y'.

Die Erfindung betrifft auch ein Verfahren zur Auslegung einer zuvor beschriebenen Sende-Empfangsspulenanordnung, wobei eine Optimierung durchgeführt wird. Erfindungsgemäß wird als Zielfunktion für die Optimierung entweder das Signal-zu-Rausch-Verhältnis SNR eines vorgegebenen NMR-Experimentes gewählt oder die Zielfunktion umfasst mindestens zwei Größen, die das Signal-zu-Rausch-Verhältnis (SNR) beeinflussen. Erfindungsgemäß erfolgt die Optimierung mittels Optimierungsparameter, von denen mindestens zwei ausgewählte Optimierungsparameter über den Verlauf der Länge des elektrischen Leiters variieren und aus den folgenden Parametern ausgewählt werden: Steigung S, Neigung T, Leiterbahnbreite W.

Ein NMR-Experiment gibt insbesondere vor: die Probe, insbesondere Art und Anzahl der anzuregenden Spins sowie Kopplungskonstanten zwischen diesen Spins, Winkel $\Theta$ der Längsachse Z' der Sende-Empfangsspule gegenüber dem statischen Magnetfeld B0 (Z-Richtung), Anregungspulssequenz (inklusive gesendeter Leistung auf einem oder mehreren Kanälen, Relaxationszeit der Spins, Rotationsgeschwindigkeit der Messprobe um die Längsachse Z' der Sende-Empfangsspule.

Die Zielfunktion der Optimierung kann also erfindungsgemäß das SNR selbst umfassen oder mehrere das SNR beeinflussende Größen, die gewichtet in die Zielfunktion eingehen können. Alternativ kann die Zielfunktion aus mehreren Teilfunktionen bestehen, bspw. je eine Teilfunktion für jede ausgewählte, das SNR beeinflussende Größe, die iterativ optimiert werden.

Durch die erfindungsgemäße Optimierung mit variierenden Optimierungsparametern können Abschirmeffekte, die durch den elektrischen Leiter der Sende-Empfangsspule selbst entstehen, kompensiert werden. Dadurch ergibt sich, insbesondere für ausgedehnte, beispielsweise bandförmige Leiter, eine Verbesserung der Qualität (Homogenität) des von der Sende-Empfangsspule erzeugten HF-Magnetfelds B1 sowie der Signalstärke des NMR-Signals (Amplitude des von der Sende-Empfangsspule erzeugten HF-Magnetfelds B1). Dabei lässt die erfindungsgemäße Optimierung vorzugsweise HF-Magnetfelder zu, die eine Komponente in Richtung der Längsachse Z' der Sende-Empfangsspule haben. Die erfindungsgemäße Optimierung erfolgt also nicht mit dem Ziel Z'-Komponenten des HF-Magnetfelds B1 zu vermeiden. Im Gegensatz zu [Sun et. al.] und [Barbara et al.] geht die Erfindung also nicht davon aus, dass die beste Lösung diejenige ist, bei der das erzeugte HF-Magnetfeld B1 möglichst vollumfänglich in der XY-Ebene zu liegen kommt. Insbesondere berücksichtigt das erfindungsgemäße Verfahren resistive Verluste, die durch Abschirmströme auf den Spulenleitern entstehen und Reduktion des B1 Feldes aufgrund dieser Abschirmströme. Diese Verluste steigen für ausgedehnte Leiter (Leiter mit nicht verschwindender Leiterbahnbreite) mit steigender Neigung T an, so dass in der Regel die beste Effizienz für HF-Magnetfelder B1 erreicht wird, die nicht vollständig in der XY-Ebene (Ebene senkrecht zum B0-Feld eines Hauptfeldmagneten) liegen.

Besonders vorteilhaft ist die Verwendung eines Bandleiters mit einer Dicke von $3\delta$ bis $10\delta$, mit $\delta$ = Eindringtiefe bei gegebener Frequenz und bei gegebenem Spulenmaterial.

Vorzugsweise umfasst die Optimierung:

a) Festlegung der Anzahl N der Windungen, wobei N $\geq$ 3,

b) Bestimmen je eines Startwerts für die Optimierungsparameter,

c) Bestimmen der Zielfunktion mit den bestimmten Startwerten für die Optimierungsparameter,

d) Anpassen der Optimierungsparameter, wobei für die mindestens zwei ausgewählten Parameter eine nicht konstante Funktion in Abhängigkeit eines Laufparameters t, der zwischen 0 und der Windungszahl N der Sende-

6

Empfangsspulenanordnung läuft, verwendet wird, mit $t \in \mathbb{R}$ und $0 \le t \le N, N \in \mathbb{R}$

e) Bestimmen der Zielfunktion mit den angepassten Optimierungsparametern,

f) Wiederholen der Schritte d)-e) bis sich die Zielfunktion innerhalb eines vorgegebenen Ziel-Intervalls befinden.

Bevorzugt wird die Anzahl N der Windungen ganz- oder halbzahlig ( $N \in \mathbb{N}$ oder 2N $\in \mathbb{N}$ ) gewählt. Prinzipiell kann $N \in \mathbb{R}$ sein.

Bei einer bevorzugten Variante des erfindungsgemäßen Verfahrens ist eine der mindestens zwei das SNR beeinflussenden Größen der Zielfunktion die radiale Homogenität des HF-Magnetfelds B1, welches im Betrieb innerhalb des FOV von der Sende-Empfangsspule erzeugt wird, und die ausgewählten Optimierungsparameter sind die Steigung S und die Neigung T der Windungen.

Die Zielfunktion umfasst bei dieser Variante also u.a. die axiale und radiale Homogenität, die über die Neigung T und die Steigung S optimiert werden.

Durch Verwendung der radialen Homogenität als Teil der Zielfunktion kann das SNR insbesondere von Kreuzpolarisation (CP)- und Doppel-Kreuzpolarisation (DCP)-Experimenten mit einer Kreuzspulenanordnung mit einer erfindungsgemäßen Sende-Empfangsspule verbessert werden. Während sich nämlich eine unendlich lange Solenoidspule (außer in unmittelbarer Nähe zu den Windungen) durch eine sehr hohe radiale Homogenität auszeichnet, weisen kurze Solenoidspulen eine verringerte radiale Homogenität im Endbereich (an den axialen Enden) auf, selbst wenn die axiale Homogenität durch Reduktion der Steigung der Windungen im Endbereich korrigiert wurde. Wird eine solche kurze Solenoidspule in MAS-NMR-Messköpfen eingesetzt, ist die Längsachse Z' der Sende-Empfangsspule um den magischen Winkel um die Y-Achse gegenüber der Achse Z des statischen Magnetfeldes geneigt. Unter diesen Umständen nimmt die radiale Homogenität des HF-Magnetfelds B1 im Randbereich stark ab. Dies wirkt sich besonders auf das erreichbare SNR von Doppel-Kreuzpolarisation(CP)- und Doppel-Kreuzpolarisation(DCP)-Experimenten negativ aus, wenn also neben der ersten noch eine weitere Sende-Empfangsspule vorgesehen ist und die beiden Sende-Empfangsspulen auf unterschiedliche Messfrequenzen abgestimmt sind, insbesondere, wenn die weitere Sende-Empfangsspule als Sattelspule und/oder Resonator ausgeführt ist, dessen B2-Feld in Y-Richtung zeigt (wobei die Längsachse Z' der als Solenoidspule ausgeführte erste Sende-Empfangsspule sich in der YZ-Ebene befindet).

Die Optimierung der radialen Homogenität erfolgt auf einer vorgegebener Länge L' innerhalb des FOV parallel zur Längsachse Z' der Sende-Empfangsspule (Plateaubereich). Je ähnlicher die B1-Intensitätswerte entlang des Plateaubereichs (also für verschiedene Radien) sind, desto besser ist die radiale Homogenität.

Vorzugsweise wird die Neigung T der Windungen über den Verlauf der Länge des elektrischen Leiters so angepasst, dass die Neigung T an den axialen Enden der ersten Sende-Empfangsspule kleiner ist als am axialen Zentrum.

Für jeden Leiterquerschnitt (also insbesondere für jede Leiterbahnbreite W) und für jede Steigung S existiert eine Neigung T, für die die B1-Feld-Amplitude maximiert wird. Eine variable Neigung T mit Maximum im zentralen Bereich der Sende-Empfangsspule ermöglicht es, die Effizienz der Sende-Empfangsspule bei gleichzeitig korrigierter radialer Homogenität zu maximieren. Insbesondere weisen die äußersten 1-2 Windungen eine gegenüber der Neigung T der zentraler angeordneten Windungen eine geringere Neigung T auf.

Vorzugsweise ist mindestens eine Halbwindung im Zentrum der Sende-Empfangsspulenanordnung stärker gegen die Längsachs Z' der Sende-Empfangsspule geneigt als die Längsachse Z' der Sende-Empfangsspule gegenüber einer durch ein statisches Magnetfeld B0 des vorgegebenen NMR-Experiments definierten Z-Achse. Dadurch kann bei ausgedehnten Leitern erreicht werden, dass das B1 Feld in XY-Ebene verläuft. Die Lösung, die man mit dieser Vorschrift findet ist i.d.R. nicht die Lösung mit maximaler Effizienz, sondern eine Lösung mit maximaler erzeugter Feldstärke pro Einheitsstrom bei reduzierter Spulengüte. Dies ist insbesondere dann vorteilhaft, wenn sehr viel Verlust in anderen Bereichen des Probenkopfes auftreten und daher die Spulengüte nicht durch die Leiterverluste dominiert werden (sondern z.B. durch dielektrische Verluste...).

Das Verhältnisses D/W von Spaltbreite D zu einer benachbarten Windung und Leiterbahnbreite W wird vorzugsweise in Abhängigkeit der Neigung der Windungen eingestellt. Die Spaltbreite D des Leiters an der Position t ist der Abstand des elektrischen Leiters zwischen Position t und Position t+2n oder t-2 n.

Wird neben der Neigung T das Verhältnis D/W von Spaltbreite D und Leiterbahnbreite W als Optimierungsparameter ausgewählt, so variiert das Verhältnis D/W, i.e. entweder die Leiterbahnbreite oder die Spaltbreite oder beide Parameter entlang der Länge des Leiters, wobei das Verhältnis D/W in Abhängigkeit von der Neigung T gewählt wird. D.h. je größer die Windungsneigung T, desto grösser wird auch das das Verhältnis D/W von Spaltbreite D und Leiterbahnbreite W gewählt. Insbesondere variiert D/W auch über die Länge einer einzelnen Windung, wobei D/W mindestens zwei Minima aufweist.

Bei einer vorteilhaften Variante des erfindungsgemäßen Verfahrens ist eine der mindestens zwei das Signal-zu-Rausch-Verhältnis SNR beeinflussenden Größen die axiale Homogenität des von der Sende-Empfangsspule erzeugten HF-Magnetfelds B1. Dies erfolgt insbesondere durch Variation der Steigung der Windungen. Durch Optimierung der axialen Homogenität (Homogenität entlang der Längsachse Z' (on-axis)) kann insbesondere das SNR von Pulssequenzen mit mehreren (90° und 180°) Pulsen verbessert bzw. das nutzbare Volumen des aktiven Bereichs der Sende-Empfangsspule, in dem eine gewünschte Signalqualität, insbesondere eine gewünschte Signalamplitude erreicht wird, vergrößert werden.

Für endliche Sende-Empfangsspulen fällt die Amplitude des B1-Magnetfelds an den axialen Enden ab. Durch eine Verringerung der Steigung an den axialen Enden kann erreicht werden, dass die Windungen dichter beieinanderliegen. Somit kann die aufgrund der Endlichkeit der Sende-Empfangsspule fehlende Stromdichte kompensiert werden. Eine Verbesserung der Homogenität entlang der Längsachse Z' für kurze Sende-Empfangsspule, die fern der Eigenresonanzen betrieben werden, ergibt sich daher insbesondere dann, wenn die Steigung an den axialen Enden der Sende-Empfangsspule kleiner gewählt wird als am axialen Zentrum.

Beim Betrieb nahe der Eigenresonanz ist beim Verschalten der Sende-Empfangsspule darauf zu achten, dass die elektrischen Potentiale so eingestellt werden, dass die Sende-Empfangsspule symmetrisch schwingt, da sich sonst die Stromverteilung verändert. Alternativ kann durch ein Anpassnetzwerk eine Potentialverteilung so eingestellt werden, dass das Maximum nicht im Zentrum der Solenoidspule ist, was jedoch zu höheren elektrischen Feldern und somit höheren Verlusten in verlustbehafteten Messproben führt.

Eine weitere Variante des erfindungsgemäßen Verfahrens sieht vor, dass eine der mindestens zwei das Signal-zu-Rausch-Verhältnis SNR beeinflussende Größen die B1-Amplitude/Einheitsleistung ist und die ausgewählte Optimierungsparameter die Steigung S und die Leiterbahnbreite W sind. Eine Optimierung der B1-Amplitude/Einheitsleistung umfasst auch eine iterative Optimierung von B1-Amplitude/Einheitsstrom und Güte. Mit der B1-Amplitude/Einheitsleistung wird die Effizienz der Sende-Empfangsspule verbessert.

Insbesondere bei Verwendung von flachen Bandleitern als elektrischer Leiter (mit einer Leiterbahndicke von $3\delta$ bis $10\delta$ mit $\delta$ = Eindringtiefe) kann die Empfindlichkeit (B1-Amplitude / Einheitsleistung) der Sende-Empfangsspule durch Variation des Verhältnisses D/W von Spaltbreite D und Leiterbahnbreite W beeinflusst werden. Insbesondere ist eine Abweichung für den aus dem Stand der Technik [Mispelter] für Solenoidspulen in der NMR bekannten Wert P/W = 1.5 ... 1.667 vorgesehen. Für sehr dünne Metallisierungen und insbesondere auch für Spulen mit einer deutlichen größeren Länge als Durchmesser wird die höchste Effizienz einer Solenoidspule erfindungsgemäß bei einem Verhältnis von P/W < 1.5, insbesondere < 1.25 erreicht, (i.e. bei einer Ganghöhe P von 1 mm bei einer Leiterbahnbreite von 0.8 mm oder mehr). Das Verhältnis von Spaltbreite D zu Leiterbahnbreite D/W beträgt daher vorzugsweise D/W < 0.5, vorzugsweise D/W= 0.25. Vorzugsweise ist also die Spaltbreite D zwischen den Windungen kleiner oder gleich der halben Leiterbahnbreite W, insbesondere kleiner oder gleich wie ein Viertel der Leiterbreite.

Vorzugsweise wird die Neigung T der Windungen im axialen Zentrum der Sende-Empfangsspule so gewählt, dass die B1-Amplitude des von der Sende-Empfangsspule erzeugten HF-Magnetfelds B1 pro Einheitsleistung für ein gegebenes Verhältnis von Spaltbreite D zu Leiterbahnbreite W maximiert wird. Die Neigung T ist hier also Optimierungsparameter.

Eine spezielle Variante des erfindungsgemäßen Verfahrens sieht vor, dass die Sende-Empfangsspulenanordnung eine weitere Sende-Empfangsspule zur Erzeugung eines weiteren HF-Magnetfeldes B2 umfasst und eine der mindestens zwei das Signal-zu-Rausch-Verhältnis SNR beeinflussende Größen das Verhältnis B1/B2 der Amplituden/Einheitsleistung des ersten HF-Magnetfeldes B1 und des weiteren HF-Magnetfeldes B2 ist.

Zur Steigerung der Effizienz der Spule ist es vorteilhaft, wenn der elektrische Leiter eine Leiterdicke d und einen Verrundungsradius r aufweist, wobei die Leiterdicke d und/oder der Verrundungsradius r des elektrischen Leiters als zusätzliche Optimierungsparameter verwendet wird/werden, der/die über den Verlauf der Länge des elektrischen Leiters variiert/variieren. Hierdurch wird eine Kumulation von Strom an der Ecke "verschmiert", die Güte erhöht und somit die Effizienz der Spule gesteigert, ohne einen wesentlichen Einfluss auf anderen Parameter zu haben.

Die Erfindung betrifft auch ein Verfahren zur Herstellung einer Sende-Empfangsspule. Dabei wird die Sende-Empfangsspule nach einem zuvor beschriebenen Verfahren ausgelegt, und die Geometrie der Spule wird gemäß der Auslegung aus einem metallischen Rohr gefertigt, insbesondere mittels Fräsen, Laser- oder Wasserstrahlschneiden.

Vorteilhaft hieran ist die erreichbare geringe Leiterbahndicke d. Weiterhin kann eine solche Sende-Empfangsspule ohne Träger hergestellt werden, insbesondere ohne Träger zwischen Leiter und Messprobe, so dass die Effizienz der Sende-Empfangsspule erhöht wird. Zur weiteren Verbesserung der Leitfähigkeit können Verfahren zur Verrundung der Schnittkanten (z. B. Trovalisieren) des Leiters eingesetzt werden, oder die Schnittkanten beispielsweise durch Fräsen verrundet werden.

Alternativ kann die Geometrie der Spule gemäß der Auslegung mittels eines beschichteten Trägers realisiert werden, wobei die Beschichtung durch Strukturierung, z.B. Ätzen, Fräsen, Laserablation, usw., gefertigt wird. Die Fertigung einer Beschichtung auf einem Träger erlaubt die Herstellung von noch dünneren Schichten. Der Träger hilft, die mechanische Robustheit zu erhöhen, und kann als Wärmeleiter verwendet werden, z.B. um eine kryogene Spule mittels Kaltfinger zu kühlen. Die Beschichtung ist vorzugsweise supraleitend.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Fig. 1      zeigt eine erfindungsgemäße Sende-Empfangsspule mit konstanter Neigung im Zentrum und reduzierter Neigung der äußersten beiden Windungen, variierender Steigung und periodisch variierender Leiterbahnbreite mit zwei Maxima pro Windung für eine Einzelspulenkonfiguration.

Fig. 2      zeigt eine Sende-Empfangsspule mit variierender Neigung, variierender Steigung und periodisch variierender Leiterbahnbreite mit zwei Maxima pro Windung für eine Kreuzspulenkonfiguration.

Fig. 3a      zeigt eine Aufsicht einer erfindungsgemäßen Sende-Empfangsspulenanordnung in einer Kreuzspulenkonfiguration mit einer ersten Sende-Empfangsspule gemäß Fig. 2.

Fig. 3b      zeigt eine perspektivische Darstellung der Sende-Empfangsspulenanordnung aus Fig. 3a.

Fig. 4      zeigt eine erfindungsgemäße Sende-Empfangsspule mit variierender Neigung, variierender Steigung und periodisch variierender Leiterbahnbreite mit vier Maxima pro Windung für eine Kreuzspulenkonfiguration.

Fig. 5a      zeigt eine Aufsicht einer erfindungsgemäßen Sende-Empfangsspulenanordnung in einer Kreuzspulenkonfiguration mit einer zero-pitch SendeEmpfangsspule mit periodisch variierender Steigung und periodisch variierender Leiterbahnbreite.

Fig. 5b      zeigt eine perspektivische Darstellung der Sende-Empfangsspulenanordnung aus Fig. 5a.

Fig. 6      zeigt eine erfindungsgemäße Sende-Empfangsspule für eine Einzelspulenkonfiguration, bei der neben der Steigung und der Leiterbahnbreite auch die Neigung variiert, wobei die Leiterbahnbreite periodisch mit jeweils einem Maximum in jeder Umdrehung variiert.

Fig. 7      zeigt eine erfindungsgemäße Sende-Empfangsspule mit von Windung zu Windung variierender Steigung, variierender Leiterbahnbreite und stark variierender Neigung, wobei die Leiterbahnbreite periodisch variiert.

Fig. 8      zeigt eine erfindungsgemäße Sende-Empfangsspule mit konstanter Steigung, variierender Leiterbahnbreite und variierender Neigung.

Fig. 9      zeigt einen erfindungsgemäßen NMR-Probenkopf.

Fig. 10a      zeigt einen Ausschnitt eines solenoidförmigen Spulenabschnitts zur Veranschaulichung der Spulenparameter bei einer Spule mit geneigten Windungen.

Fig. 10b      zeigt einen Ausschnitt eines solenoidförmigen Spulenabschnitts zur Veranschaulichung der Spulenparameter bei einer Spule mit nicht geneigten Windungen.

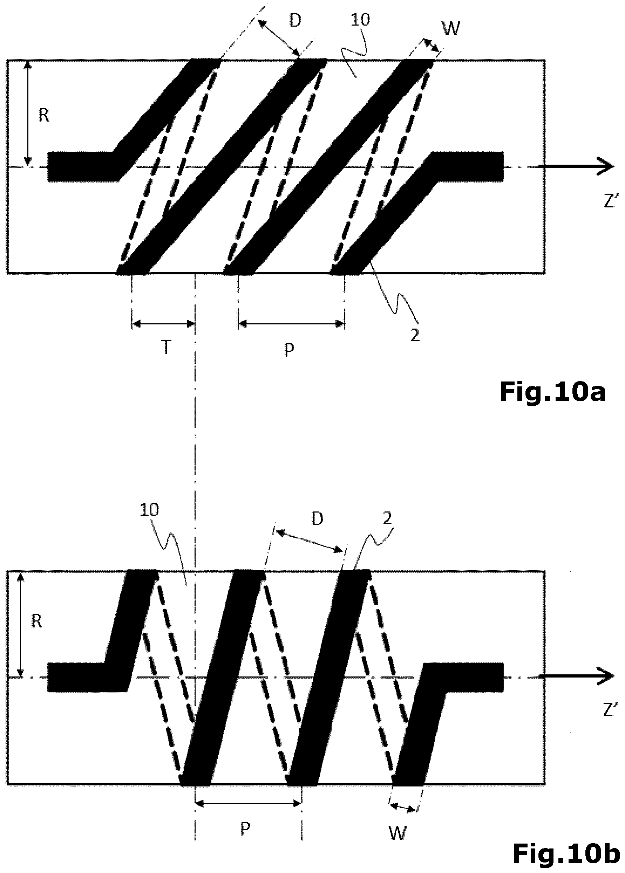

Die erfindungsgemäße Sende-Empfangsspule weist Spulenparameter auf, die entlang des Verlaufs des elektrischen Leiters der Sende-Empfangsspule variieren. In **Fig. 10a** und **Fig. 10b** ist jeweils ein Ausschnitt einer solenoidförmigen Spule mit einem bandförmigen Leiter **2** (Leiterbahn) gezeigt, anhand derer zunächst einige der Spulenparameter veranschaulicht werden. Die solenoidförmigen Spulen in Fig. 10a und Fig. 10b sind entlang einer Längsachse **Z'** (Spulenachse) angeordnet, wobei die Längsachse Z' senkrecht auf einer X'Y'-Ebene steht (nicht gezeigt). Die solenoidförmigen Spulen werden durch die Leiterbahnbreite **W** der Leiterbahn 2, einer Spaltbreite **D** eines Zwischenraums **10,** einer lokalen Steigung S (nicht dargestellt) und/oder einer Ganghöhe **P** der Windungen, einer Neigung **T** der Windungen und einem Radius **R** der Windungen parametrisiert. In der hier gezeigten Ausführungsform sind insgesamt drei Windungen gezeigt.

Die Leiterbahnbreite W gibt die Breite der Leiterbahn 2 an. Die Leiterbahnbreite W ist die Breite der Leiterbahn senkrecht zur Leitermitte. In den in Fig. 10a und Fig. 10b gezeigten Spulen ist die Leiterbahnbreite W entlang der Längsachse Z' konstant (d. h. W = const.).

Die Spaltbreite D gibt die Breite des Zwischenraums 10 zwischen dem bandförmigen Leiter benachbarter Windungen der Leiterbahn 2 an.

Die Ganghöhe P der Windungen gibt den Vortrieb in Z'-Richtung einer kompletten Windung an und wird über die Zentrallinie der Leiterbahn 2 bestimmt. Eine konstante Ganghöhe P schließt nicht aus, dass die lokale Steigung S innerhalb einer Windung variiert.

Die Neigung T der Windungen gibt die Neigung der Windungen gegenüber der Längsachse Z' an und entspricht der Amplitude einer sinusförmigen Modulation der Z'-Position der Leitermittelebene über eine Windung. Bei über mehrere Windungen konstanter Steigung und Neigung kann sie einfach bestimmt werden aus Max(Z(t) - Z(t+1)) - S)/2, wobei t im Intervall tn...tn+1 variiert.

Der Radius R der Windungen gibt den Radius an, auf dem die Leiterbahn 2 liegt.

Die in Fig. 10a und Fig. 10b gezeigten Solenoidspulen weisen jeweils eine konstante Leiterbahnbreite W, eine konstante Spaltbreite D, konstante Steigung S und damit auch eine konstante Ganghöhe P auf, wobei es sich bei der im Fig. 10a gezeigten Spule um eine geneigte Spule (T ≠ 0) und bei der in Fig. 10b gezeigten Spule um eine nicht geneigte Spule (T = 0) handelt.

Allgemein ist die Zentrallinie der Leiterbahn 2 in kartesischen Koordinaten definiert als

$$\begin{pmatrix} R(t) * \sin(2\pi t) \\ R(t) * \cos(2\pi t) \\ P(t) * t + T(t) * \cos(2\pi t + \varphi) \end{pmatrix} \text{ mit } t \in \{0...N\},$$

wobei φ: Orientierung der Neigung der Windungen..

Die Einhüllende der Leiterbahn 2 in kartesischen Koordinaten ist definiert als

$$\begin{pmatrix} R(t) * \sin(2\pi t) \\ R(t) * \cos(2\pi t) \\ S(t) * t \pm W(t)/2 + T(t) * \cos(2\pi t + \varphi) \end{pmatrix} \text{ mit } t \in \{0...N\} .$$

Dabei ist die Leiterbahnbreite insbesondere $W(t) = W_0 + \Sigma W_i (\sin(2\pi t + k))^{2i}$ , die Neigung T ist konstant über jede Halbwindung. In der Regel ist die Neigungsrichtung φ = 0 (Neigung um die Y' Achse) oder n/2 (Neigung um die X' Achse) und der Radius R(t) = R.

Im Folgenden werden verschiedene Varianten der erfindungsgemäßen Sende-Empfangsspule-Geometrie beschrieben, mit denen die Performance des erfindungsgemäßen NMR-Spulenkopfs durch Variation der Spulenparameter entlang des Verlaufs des elektrischen Leiters 2 optimiert werden kann.

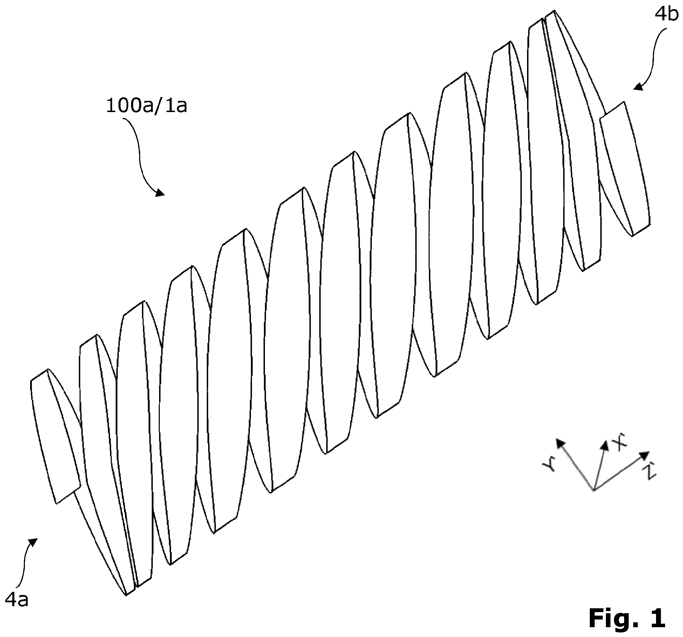

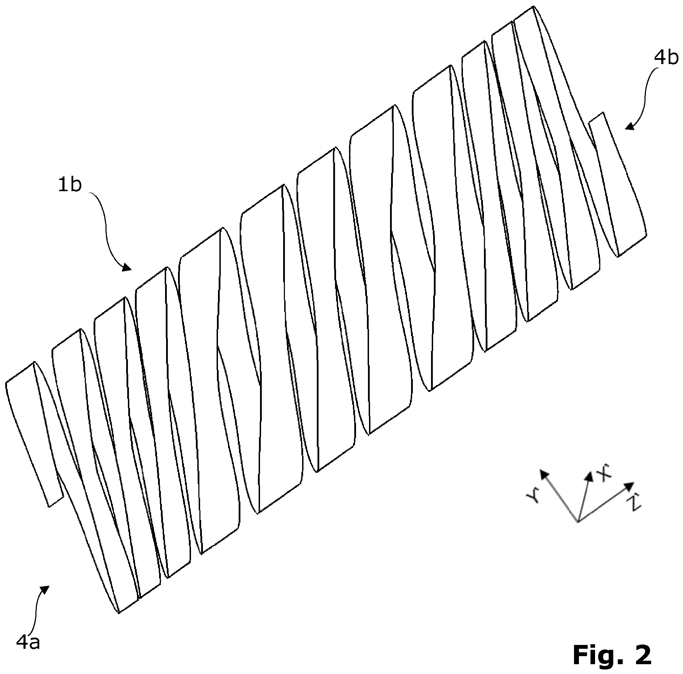

**Fig. 1** und **Fig. 2** zeigen erfindungsgemäße Sende-Empfangsspulen 1a, 1b mit konstanter Neigung T um die X'-Richtung (d.h. Neigungsrichtung φ = π/2). Die Ganghöhe P ist im mittleren Bereich der Sende-Empfangsspulen 1a, 1b konstant und verringert sich zu den beiden axialen Enden **4a, 4b** der Sende-Empfangsspulen 1a, 1b. Die Leiterbahnbreite W variiert periodisch und weist pro Windung zwei Bereiche mit maximaler Leiterbahnbreite und zwei Bereiche mit minimaler Leiterbahnbeite auf. Weiterhin gilt W(k) = W(k+0.5) = Wmin und W(k+0.25) = W(k+0.75) = Wmax.

Die erfindungsgemäß variierenden Parameter der Sende-Empfangsspulen 1a, 1b sind die Leiterbahnbreite W, sowie die Ganghöhe P und damit auch die Steigung S. In diesen Ausführungsformen ist die Steigung S pro Windung konstant. Im Allgemeinen kann sie jedoch auch über die Länge einer Windung variieren.

Die beiden Sende-Empfangsspulen 1a und 1b unterscheiden sich in der Anordnung der minimalen und maximalen Leiterbahnbreiten relativ zur Neigungsrichtung φ = π/2 respektive φ = 0 der Sende-Empfangsspulen 1a, 1b.

Prinzipiell ist es im Falle von geneigten Windungen (T ≠ 0) vorteilhaft, wenn sich die minimale Leiterbahnbreite auf der Schnittebene orthogonal zur Neigungsachse befindet. Für den Fall einer Neigung um die X' Achse, wie in Fig. 1 gezeigt, liegen die Minima der Leiterbahnbreite auf der Schnittebene der Spule mit der Y'Z' Ebene. Die Neigung führt dazu, dass eine Feldkomponente entlang einer Y'-Achse, i.e. 90° zu Z' generiert wird. Diese Feldkomponente muss die Sende-Empfangsspule "durchdringen" was erleichtert wird, wenn zwischen den Leiterabschnitten zweier Windungen eine größere Spaltbreite D vorliegt. Auf den Leitern selbst werden Abschirmströme ausgebildet, die resistive Verluste erhöhen und das Feld abschwächen und so zu Performanceverlusten führen. Durch Positionierung der Minima der Leiterbahnbreite W bzw. der Maxima der Spaltbreite D entlang der Y'Z'-Ebene und der Maxima der Leiterbahnbreite W bzw. der Minima der Spaltbreite D in Richtung der X'Z'-Ebene kann die Performance gesteigert werden, da das Verhältnis aus Spaltbreite und Leiterbahnbreite an jeder räumlichen Position optimiert werden kann

Aufgrund ihrer guten Performance ist die in Fig. 1 gezeigte Sende-Empfangsspule 1a besonders für Sende-Empfangsspulenanordnungen **100a, 100b** mit einer Einzelspulenkonfiguration geeignet.

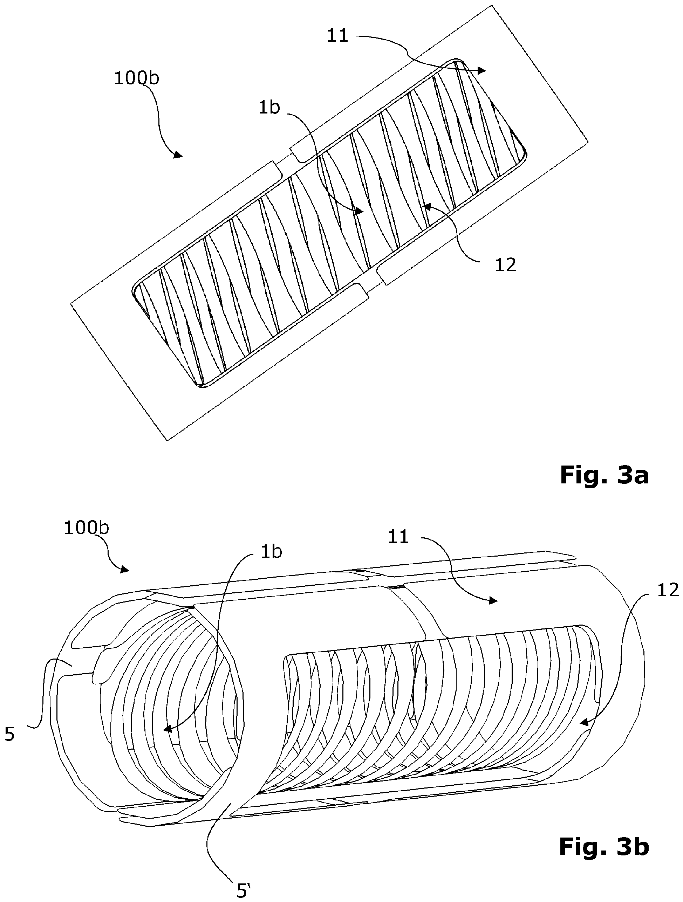

Wenn eine weitere Sende-Empfangsspule 11 (s. Fig. 3a und Fig. 3b) die ein HF-Magnetfeld B2 erzeugt, das in X' Richtung orientiert ist (i.e. eine Sattelspule, ein Resonator, ...), die erfindungsgemäße Sende-Empfangsspule 1b umgibt oder von dieser umgeben wird, dann muss dieses Feld B2 die erste Sende-Empfangsspule 1b durchdringen. Dabei stehen die Leiterbahnen (Windungen) der ersten Sende-Empfangsspule 1b "im Weg" und schirmen partiell das Feld der weiteren Sende-Empfangsspule 11 ab. In diesem Falle kann die Performanz der weiteren Sende-Empfangsspule 11 optimiert werden, indem die Leiterbahnbreite W der ersten Sende-Empfangsspule 1b in Richtung der X'-Achse reduziert wird, wie in Fig. 2 gezeigt. Diese Optimierung der weiteren Sende-Empfangsspule 11 geht "zu Lasten" der Performanz der ersten Sende-Empfangsspule 1b, bietet aber eine bessere Durchlässigkeit in X'-Richtung. Daher ist die in Fig. 2 gezeigte Sende-Empfangsspule 1b besonders für Sende-Empfangsspulenanordnungen **100b** mit einer Kreuzspulenkonfiguration geeignet.

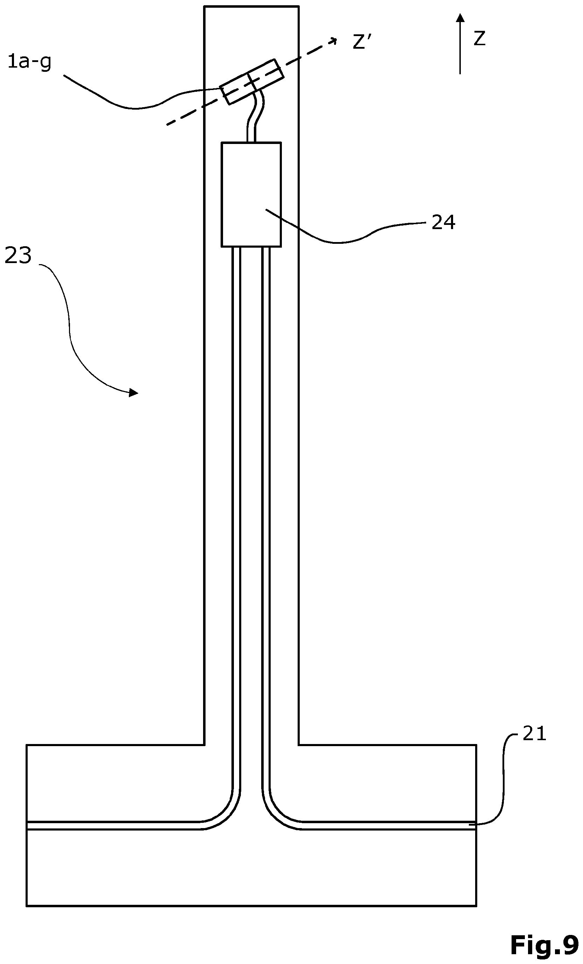

**Fig. 3a** und **Fig. 3b** zeigen die Sende-Empfangsspulenanordnung **100b** mit einer solchen Sende-Empfangsspule 1b und einer weiteren Sende-Empfangsspule **11** in Kreuzspulenkonfiguration. Die Sende-Empfangsspulenanordnung 100b umfasst die in Fig. 2 gezeigte erste Sende-Empfangsspule 1b zur Erzeugung des ersten HF-Magnetfelds B1 und die weitere Sende-Empfangsspule 11 zur Erzeugung des zweiten HF-Magnetfelds B2 für einen erfindungsgemäßen NMR-Probenkopf 23 (s. Fig. 9). Die erste Sende-Empfangsspule 1b ist hier koaxial, radial innerhalb der weiteren Sende-Empfangsspule 11 angeordnet, so dass das von der weiteren Sende-Empfangsspule 11 erzeugte zweite Magnetfeld B2 im Wesentlichen senkrecht auf dem von der ersten Sende-Empfangsspule 1b erzeugten ersten Magnetfeld B1 steht. Die weitere Sende-Empfangsspule 11 ist hier als Alderman-Grant-Resonator bestehend aus zwei Hälften **5** und **5'** ausgebildet und umgibt die erste Sende-Empfangsspule 1b radial, wobei die weitere Sende-Empfangsspule 11 zwei gegenüberliegende Öffnungen **12** ("Fenster") aufweist. Die erste Sende-Empfangsspule 1b und die weitere Sende-Empfangsspule 11 sind so zueinander ausgerichtet, dass die Bereiche der ersten Sende-Empfangsspule 1b, in denen die Leiterbahnbreite W des elektrischen Leiters 2 der ersten Sende-Empfangsspule 1 minimale Werte aufweisen, innerhalb der "Fenster" 12 der weiteren Sende-Empfangsspule 11 liegen, so dass das von der weiteren Sende-Empfangsspule 11 erzeugte zweite Magnetfeld B2 durch die Bereiche mit minimaler Leiterbahnbreite W der ersten Sende-Empfangsspule 1a verläuft. Hierdurch weist die erste Sende-Empfangsspule 1b eine hohe Transparenz für das zweite HF-Magnetfeld B2 auf. Alternativ zu der in Fig. 3a und Fig. 3b gezeigten Ausführungsform kann die weitere Sende-Empfangsspule 11 auch innerhalb der ersten Sende-Empfangsspule 1b angeordnet werden (nicht dargestellt). Ebenso kann die weitere Sende-Empfangsspule auch als Sattelspule, insbesondere als Mehrwindungssattelspule statt als Resonator ausgeführt werden (nicht dargestellt).

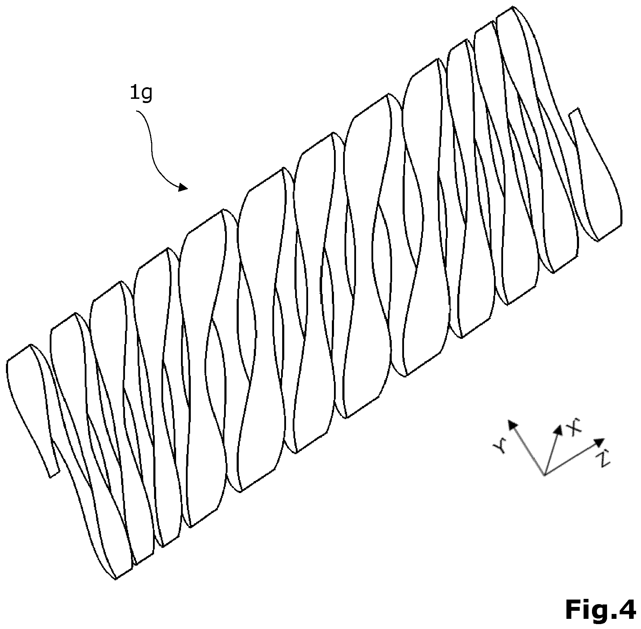

**Fig. 4** zeigt eine sehr spezielle Ausführungsform der erfindungsgemäßen Sende-Empfangsspule **1g**. Die Leiterbahnbreite W ändert sich bei der Sende-Empfangsspule 1g periodisch und weist pro Windung vier Maxima und vier Minima auf: zwei Minima entlang der Neigungsachse (X'-Richtung), um - analog zu der Sende-Empfangsspule 1b aus Fig. 2 - eine Transparenz für ein zweites HF-Magnetfeld B2 einer Kreuzspulenkonfiguration zu erzeugen, und zwei Minima senkrecht zur Neigungsachse (entlang der Y'-Richtung), um - analog zu der Sende-Empfangsspule 1a aus Fig. 1 - "sich selbst weniger im Weg zu stehen". Diese Minima optimieren i.d.R. für Sende-Empfangsspulen mit geneigten Windungen die Performance der ersten Sende-Empfangsspule 1g, wohingegen die Minima, welche die Transparenz erhöhen, die Performance der weiteren Sende-Empfangsspule (in Fig. 4 nicht gezeigt) zu Lasten der ersten Sende-Empfangsspule 1g optimieren.

Die erfindungsgemäß variierenden Parameter der Sende-Empfangsspule 1g ist die Leiterbahnbreite W, sowie die Ganghöhe P und damit auch die Steigung S sowie die Neigung T.

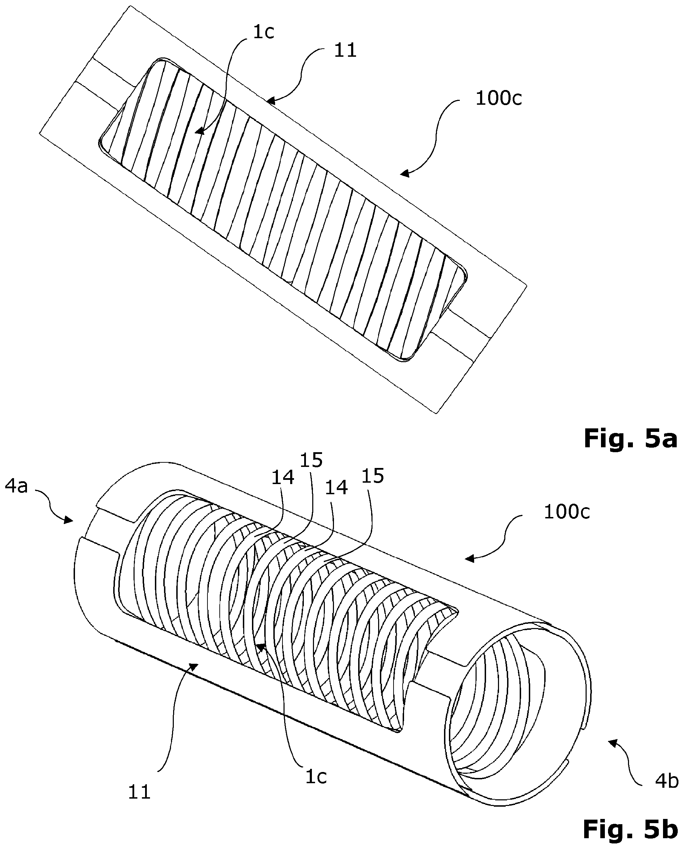

**Fig. 5a** und **Fig. 5b** zeigen eine weitere Ausführungsform einer Sende-Empfangsspulenanordnung **100c** in Kreuzspulengeometrie mit einer ersten Sende-Empfangsspule **1c**. Die Windungen der Sende-Empfangsspule 1c weisen über einen Großteil ihrer Länge eine lokale Steigung $S(t) = 0$ auf. Eine solche Windung bildet einen nicht geschlossenen Ring, d.h. $S(t) = 0$ für $t = t0 ... t0+1-\varepsilon$ oder $t = t0+ \varepsilon/2 ... t0+1-\varepsilon/2$, mit $\varepsilon > 0$, wobei $\varepsilon > 0$ einen Kurzschluss verhindert; $t = t0$ ist der Anfang der Windung. Derart gestaltete Solenoidspulen 1c sind unter dem Begriff «zero-pitch» Spule bekannt, da ein Großteil der Windung eine lokale Steigung von 0 aufweist. Die Ganghöhe P einer kompletten Windung hat jedoch einen in dieser Ausführungsform konstanten Betrag ungleich $0\ (|P| = \mathrm{const.})$. Eine solche Sende-Empfangsspule 1c kann also als Kombination von nicht geschlossenen «Ringen» ohne (lokale) Steigung und Abschnitten des elektrischen Spulenabschnitts mit Steigung $S(t) \gg 0$ konzipiert werden. Das Verhältnis W/D von Leiterbahnbreite W zu Spaltbreite D kann auf einfache Weise über die Sende-Empfangsspule 1c hinweg konstant gehalten werden, wenn die Leiterbahnbreite konstant ausgeführt wird. Dadurch kann besonders einfach die Güte der Sende-Empfangsspule 1c maximiert und/oder die elektrischen Felder minimiert werden. Die Sende-Empfangsspule 1c in Fig. 5a und 5b weist jedoch eine periodisch variierende Leiterbahnbreite W auf, wodurch auch die Spaltbreite D zwischen den Windungen periodisch variiert. Die Optimierung der Performanz der einen Sende-Empfangsspule 1c sowie deren Einfluss auf die Performanz einer Kreuzspulenanordnung ist in dieser Konfiguration besonders einfach zu berechnen. Darüber hinaus weist die Sende-Empfangsspule 1c eine konstante Neigung T auf.

Die erfindungsgemäß variierenden Parameter der Sende-Empfangsspule 1c sind die Leiterbahnbreite W, Steigung S respektive die Ganghöhe P und die Neigung T.

Die in Fig. 5a und Fig. 5b gezeigte erste Sende-Empfangsspule 1c ist vorzugsweise in einer Crisscross-Geometrie ausgebildet mit Hinwindungen **14** und Rückwindungen **15,** die vorzugsweise abwechselnd angeordnet sind.

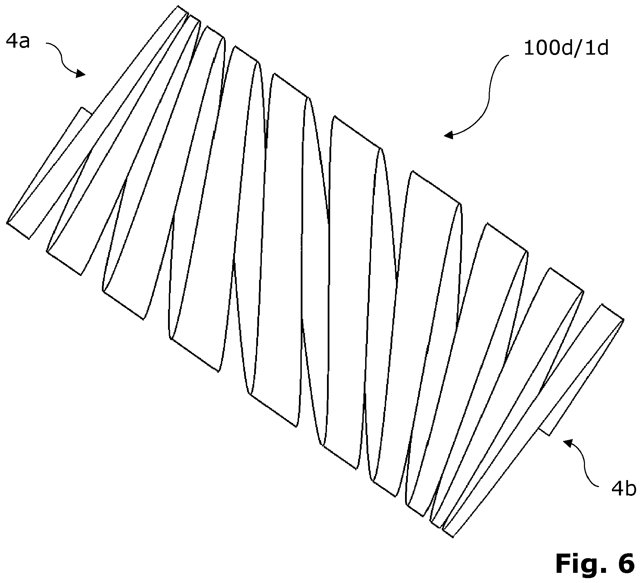

**Fig. 6** zeigt eine erfindungsgemäße Sende-Empfangsspule **1d,** bei der sowohl die lokale Steigung S als auch die Leiterbahnbreite W sowie die Neigung T variieren. Die Leiterbahnbreite W weist in jeder Windung genau ein Maximum und ein Minimum auf, wobei die über eine Windung gemittelte Leiterbahnbreite W zu den axialen Enden 4a, 4b hin abnimmt. Die Sende-Empfangsspule 1d aus Fig. 6 kann besonders gut auf mehrere Kerne abgestimmt werden und eignet sich daher insbesondere für eine 1-Spulen-Sende-Empfangsspulenanordnung **100d.**

Die erfindungsgemäß variierenden Parameter der Sende-Empfangsspule 1d sind die Leiterbahnbreite W, die Neigung T sowie die Ganghöhe P und damit auch die Steigung S. Die Neigung T an den axialen Enden der Spule ist T = 0. Dadurch kann eine solche Spule besonders einfach in einen definierten Bauraum, z.B. zwischen die Lager eines MAS-Stators montiert werden und nutzt das verfügbare Volumen besonders gut aus.

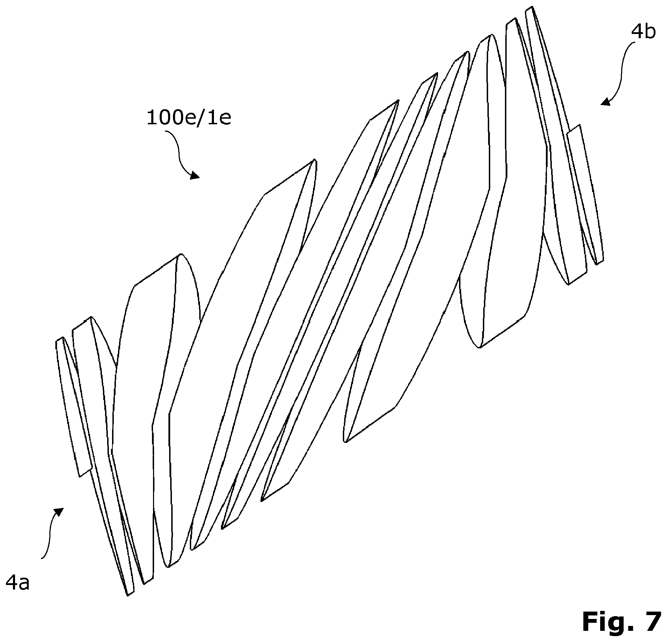

**Fig. 7** zeigt eine erfindungsgemäße Sende-Empfangsspule **1e,** bei der ebenfalls sowohl die lokale Steigung S als auch die Leiterbahnbreite W sowie die Neigung T variieren. Die Steigung S der Windungen ändert sich bei dieser Ausführungsform diskret, d.h. innerhalb einer Windung ist S(t) = konstant. Diese Diskretisierung liefert zwar nicht die optimale Homogenität, ermöglicht aber, ein ausreichend gutes Homogenitätsniveau zu erreichen. Sowohl die Leiterbahnbreite W als auch die Neigung T und die Ganghöhe P nehmen zu den axialen Enden 4a, 4b hin ab.

Die erfindungsgemäß variierenden Parameter der Sende-Empfangsspule 1e sind die Leiterbahnbreite W, die Neigung sowie die Ganghöhe P und damit auch die Steigung S.

Die Sende-Empfangsspule 1e eignet sich insbesondere für eine 1-Spulen-Sende-Empfangsspulenanordnung **100e.**

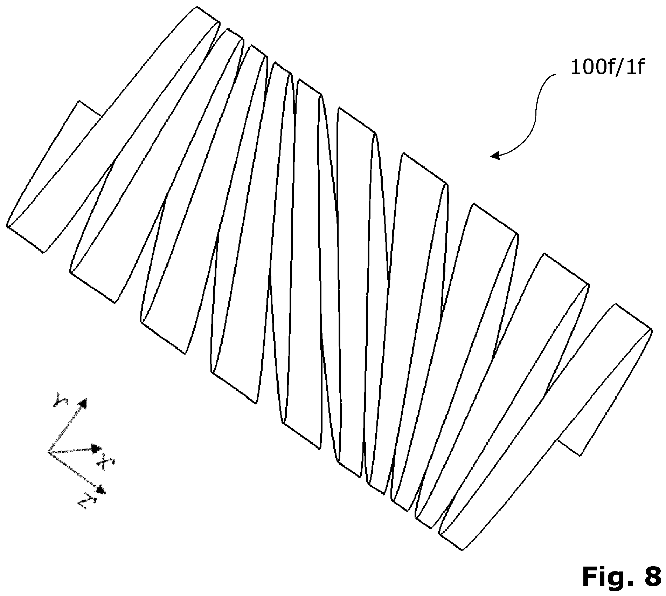

Die in **Fig. 8** gezeigte Sende-Empfangsspule **1f** hat eine konstante Ganghöhe P. Jedoch variiert die Neigung T zwischen den Windungen und die Leiterbahnbreite W.

Das Verhältnis W/D Leiterbahnbreite W zu Spaltbreite D zwischen den Windungen ist hier konstant. In Kombination mit geneigten Windungen (T ungleich 0) führt dies dazu, dass die maximalen Leiterbahnbreiten W bei Windungen der linken Hälfte der Sende-Empfangsspule 1f unten (- Y'-Richtung) angeordnet sind, während die maximalen Leiterbahnbreiten W bei Windungen der rechten Hälfte der Sende-Empfangsspule 1f oben (+Y'-Richtung) angeordnet sind. Die in Fig. 8 gezeigte Sende-Empfangsspule 1f kann besonders vorteilhaft eingesetzt werden, wenn die Gesamtlänge der Sende-Empfangsspulenanordnung begrenzt ist, z.B. für eine Sende-Empfangsspulenanordnung-Geometrie, bei der eine Sende-Empfangsspule zwischen zwei Lager eingeführt werden muss. Die Sende-Empfangsspule 1f kann insbesondere für einfache FID-Experimente eingesetzt werden, bei denen eine Maximierung der axialen und radialen Homogenität nicht notwendig ist.

Die erfindungsgemäß variierenden Parameter der Sende-Empfangsspule 1f sind die Leiterbahnbreite Wdie Spaltbreite D und die Neigung T.

Die Sende-Empfangsspule 1f eignet sich insbesondere für eine 1-Spulen-Sende-Empfangsspulenanordnung **100f.**

**Fig.** 9 zeigt eine schematische Darstellung eines erfindungsgemäßen NMR-Probenkopfs **23.** Ein statisches Magnetfeld zur Durchführung von NMR-Messungen wird während des Betriebs im hier gezeigten Beispiel parallel zur Z-Achse ausgerichtet. Der NMR-Probenkopf 23 umfasst eine erfindungsgemäße Sende-Empfangsspule 1a-g bzw. Sende-Empfangsspulenanordnung 100a-f, die an das Anpassnetzwerk 24 angeschlossen ist und weiterhin einen Spektrometeranschluss **21.** Bei dem in Fig. 9 gezeigten NMR-Probenkopf 23 handelt es sich um einen MAS (magic angle spinning) Probenkopf, bei dem die Längsachse Z' der Sende-Empfangsspule 1 gegenüber der Z-Achse, entlang der die längliche Ausdehnung des NMR-Probenkopfs 23 verläuft, vorzugsweise um den magischen Winkel θ (θ = 54,74°) verkippt ist.

Bezuaszeichenliste

1a-g      Sende-Empfangsspulen
2         elektrischer Leiter

| 4a, 4b | axialen Enden |
| 5, 5' | Hälften der weiteren Sende-Empfangsspule |
| 10 | Zwischenraum zwischen Windungen |
| 11 | weitere Sende-Empfangsspule |
| 12 | Öffnungen/Fenster der weiteren Sende-Empfangsspule |
| 21 | Spektrometeranschluss |
| 23 | NMR-Probenkopf |
| 24 | Anpassnetzwerk |
| 100a-f | Sende-Empfangsspulenanordnungen |
| Z' | Längsachse der Sende-Empfangsspule |
| W | Leiterbahnbreite |
| D | Spaltbreite |
| S | lokale Steigung |
| P | Ganghöhe |
| T | Neigung |
| R | Radius |

Literaturliste

| [Sun et. al.] | Y.H. Sun, G.E. Maciel, J. Magn. Reson., Series A, Vol. 105, p. 145-150 (1993) The Tilted Coil for NMR Experiments |
| [Barbara et al.] | US 6 359 437 B1 |
| [Privalov et al.] | F. Privalov, S. V. Dvinskikh, H.-M. Vieth |
| | J. Magn. Reson., Series A, Vol. 123, p. 157-160 (1996) |
| | Coil Design for Large-Volume High-B1 Homogeneity for Solid-State NMR Appl ications |
| [Mispelter] | J. Mispelter et al. |
| | Nmr Probeheads For Biophysical And Biomedical Experiments: Theoretical Principles And Practical Guidelines (2nd Edition), World Scientific Publishing Company, 2015, ISBN 1783268042; Seite 89 |

## Patentansprüche

1. Sende-Empfangsspulenanordnung (100a-f) für einen MAS-NMR-Probenkopf (23) mit einer ersten Sende-Empfangsspule (1a-g) mit einer Längsachse Z' zur Erzeugung eines ersten HF-Magnetfeldes B1,

   wobei die erste Sende-Empfangsspule (1a-g) zumindest einen solenoidförmigen Abschnitt aufweist, der einen elektrischen Leiter (2) aufweist mit einer Leiterbahnbreite W und $N \geq 3$ Windungen, wobei alle Windungen um die Längsachse Z' der Sende-Empfangsspule (1a-g) verlaufen, wobei der elektrische Leiter (2) eine Steigung S aufweist und jede Halbwindung mit einer Neigung T gegenüber der Längsachse Z' geneigt ist, wobei für zumindest einen Teil der Halbwindungen T#0 gilt,
   **dadurch gekennzeichnet,**
   **dass** sich mindestens zwei der folgenden Größen über den Verlauf t der Länge des elektrischen Leiters (2) der Sende-Empfangsspule (1a-g) ändern:

   • Neigung T = T(t),
   • Steigung S = S(t),
   • Leiterbahnbreite W = W(t).

2. Sende-Empfangsspulenanordnung (100a-f) nach Anspruch 1, **dadurch gekennzeichnet, dass** der elektrische Leiter (2) der ersten Sende-Empfangsspule (1a-g) als bandförmiger Leiter ausgeführt ist.

3. Sende-Empfangsspulenanordnung (100a-f) nach einem der vorhergehenden Ansprüche, **dadurch gekennzeichnet, dass** sich die Steigung S über den Verlauf t der Länge des elektrischen Leiters (2) ändert und dass sich die Leiterbahnbreite W innerhalb jeder Windung ändert, insbesondere die Leiterbahnbreite W innerhalb jeder Windung mindestens einmal zunimmt und einmal abnimmt.

4. Sende-Empfangsspulenanordnung (100d-f) nach einem der vorhergehenden Ansprüche, **dadurch gekennzeichnet, dass** sich die Steigung S und die Neigung T des elektrischen Leiters (2) der ersten Sende-Empfangsspule (1d-f) entlang des Verlaufs des elektrischen Leiters (2) ändern.

5. Sende-Empfangsspulenanordnung (100d-f) nach Anspruch 4, **dadurch gekennzeichnet, dass** die Neigung T an den axialen Enden (4a, 4b) der ersten Sende-Empfangsspule (1d, 1e, 1f, 1g) kleiner ist als am axialen Zentrum.

6. Sende-Empfangsspulenanordnung (100b, 100c) nach einem der vorhergehenden Ansprüche, **dadurch gekennzeichnet, dass** die Sende-Empfangsspulenanordnung (100b, 100c) mindestens eine weitere Sende-Empfangsspule (11) zur Erzeugung eines zweiten HF-Magnetfelds B2 radial außerhalb der ersten Sende-Empfangsspule (1b, 1c) umfasst,
dass die erste Sende-Empfangsspule (1b, 1c) und die weitere Sende-Empfangsspule (11) um die gemeinsame Längsachse Z' angeordnet sind, derart, dass durch die erste Sende-Empfangsspule (1b, 1c) und die weitere Sende-Empfangsspule (11) erzeugte HF-Magnetfelder B1, B2 senkrecht zueinander ausgerichtet sind.

7. Sende-Empfangsspulenanordnung (100c) nach einem der vorhergehenden Ansprüche, **dadurch gekennzeichnet,**

   **dass** der elektrische Leiter (2) der ersten Sende-Empfangsspule (1c) einen Hinwicklungsabschnitt und einen Rückwicklungsabschnitt umfasst, wobei der Hinwicklungsabschnitt Hinwindungen (14) umfasst und ausgehend von einem Anschlussbereich in einem vorgegebenen Windungssinn zu einem axialen Ende (4a) der Sende-Empfangsspule (1c) führt, wobei der Rückwicklungsabschnitt Rückwindungen (15) umfasst und ausgehend vom axialen Ende (4b) der ersten Sende-Empfangsspule (1c) im vorgegebenen Windungssinn zum Anschlussbereich führt, wobei die Windungen des Rückwicklungsabschnitts eine Steigung S mit entgegengesetztem Vorzeichen zu denen des Hinwicklungsabschnitts aufweisen, und
   **dass** Hin- und Rückwindungen des elektrischen Leiters (2) mit Ausnahme von Überkreuzungsbereichen, in denen sich die Hin- und Rückwindungen überkreuzen, auf einer gemeinsamen Zylindermantelfläche um die Längsachse Z' angeordnet sind.

8. MAS-NMR-Probenkopf (23) mit einer Sende-Empfangsspulenanordnung (100a-f) nach einem der vorhergehenden Ansprüche.

9. Verfahren zur Auslegung einer Sende-Empfangsspulenanordnung (100a-f) nach einem der Ansprüche 1 bis 7, wobei eine Optimierung durchgeführt wird,
   **dadurch gekennzeichnet,**

   **dass** als Zielfunktion für die Optimierung entweder das Signal-zu-Rausch-Verhältnis SNR eines vorgegebenen NMR-Experimentes gewählt wird oder dass die Zielfunktion mindestens zwei Größen umfasst, die das Signal-zu-Rausch-Verhältnis SNR beeinflussen, und
   **dass** die Optimierung mittels Optimierungsparameter erfolgt, von denen mindestens zwei ausgewählte Optimierungsparameter über den Verlauf der Länge des elektrischen Leiters (2) variieren und aus folgenden Parametern ausgewählt werden:

   - Steigung S,
   - Neigung T,
   - Leiterbahnbreite W.

10. Verfahren nach Anspruch 9, **dadurch gekennzeichnet, dass** die Optimierung umfasst:

    a) Festlegung der Anzahl N der Windungen, wobei $N \geq 3$,
    b) Bestimmen je eines Startwerts für die Optimierungsparameter,
    c) Bestimmen der Zielfunktion mit den bestimmten Startwerten für die Optimierungsparameter,
    d) Anpassen der Optimierungsparameter, wobei für die mindestens zwei ausgewählten Parameter eine nicht konstante Funktion in Abhängigkeit eines Laufparameters t, der zwischen 0 und der Windungszahl N der Sende-Empfangsspulenanordnung (100a-f) läuft, verwendet wird, mit $t \in \mathbb{R}$ und $0 \leq t \leq N$,

e) Bestimmen der Zielfunktion mit den angepassten Optimierungsparametern,

f) Wiederholen der Schritte d)-e) bis sich die Zielfunktion innerhalb eines vorgegebenen Ziel-Intervalls befindet.

11. Verfahren nach Anspruch 9 oder 10, **dadurch gekennzeichnet, dass** eine der mindestens zwei das Signal-zu-Rausch-Verhältnis SNR beeinflussenden Größen der Zielfunktion die radiale Homogenität des HF-Magnetfelds B1 ist, welches im Betrieb innerhalb des Field of Views von der Sende-Empfangsspule (1d, 1e, 1f, 1g) erzeugt wird, und die ausgewählten Optimierungsparameter die Steigung S und die Neigung T der Windungen sind.

12. Verfahren nach Anspruch 11, **dadurch gekennzeichnet, dass** die Neigung T der Windungen über den Verlauf der Länge des elektrischen Leiters (2) so angepasst wird, dass die Neigung T an den axialen Enden (4a, 4b) der ersten Sende-Empfangsspule (1d, 1e, 1f, 1g) kleiner ist als am axialen Zentrum der ersten Sende-Empfangsspule (1d, 1e, 1f, 1g).

13. Verfahren nach einem der Ansprüche 9 bis 12, **dadurch gekennzeichnet, dass** eine der mindestens zwei das Signal-zu-Rausch-Verhältnis SNR beeinflussenden Größen der Zielfunktion die axiale Homogenität des von der Sende-Empfangsspule (1a-e, 1g) erzeugten HF-Magnetfelds B1 ist.

14. Verfahren nach Anspruch 9 oder 10, **dadurch gekennzeichnet, dass** eine der mindestens zwei das Signal-zu-Rausch-Verhältnis SNR beeinflussenden Größen der Zielfunktion die B1-Amplitude/Einheitsleistung ist und die ausgewählten Optimierungsparameter die Steigung S und die Leiterbahnbreite W sind.

15. Verfahren nach einem der Ansprüche 9 bis 14, **dadurch gekennzeichnet, dass** die Neigung T der Windungen im Zentrum der Sende-Empfangsspule (1a-g), so gewählt wird, dass die B1-Amplitude/Einheitsleistung für ein gegebenes Verhältnis S/W von Steigung S zu Leiterbahnbreite W maximiert wird.

16. Verfahren nach einem der Ansprüche 9 bis 15, **dadurch gekennzeichnet, dass** die Sende-Empfangsspulenanordnung (100b, 100c) eine weitere Sende-Empfangsspule (11) zur Erzeugung eines weiteren HF-Magnetfeldes B2, umfasst und eine der mindestens zwei das Signal-zu-Rausch-Verhältnis SNR beeinflussenden Größen der Zielfunktion das Verhältnis B1/B2 der Amplituden/Einheitsleistung des ersten HF-Magnetfeldes B1 und des weiteren HF-Magnetfeldes B2 ist.

17. Verfahren nach einem der Ansprüche 9 bis 16, **dadurch gekennzeichnet, dass** der elektrische Leiter (2) eine Leiterdicke d und einen Verrundungsradius r aufweist, wobei die Leiterdicke d und/oder der Verrundungsradius r des elektrischen Leiters (2) als zusätzliche Optimierungsparameter verwendet wird/werden, der/die über den Verlauf der Länge des elektrischen Leiters (2) variiert/variieren.

18. Verfahren zur Herstellung einer Sende-Empfangsspule (1a-g), **dadurch gekennzeichnet,**

**dass** die Sende-Empfangsspule (1a-g) nach einem Verfahren nach einem der Ansprüche 9 bis 17 ausgelegt wird, und
**dass** die Geometrie der Sende-Empfangsspule (1a-g) gemäß der Auslegung aus einem metallischen Rohr gefertigt wird, insbesondere mittels Fräsen, Laser- oder Wasserstrahlschneiden oder dass die Geometrie der Sende-Empfangsspule (1a-g) gemäß der Auslegung mittels eines beschichteten Trägers realisiert wird, wobei die Beschichtung durch Strukturierung, z.B. Ätzen, Fräsen oder Laserablation gefertigt wird.

Fig. 1

Fig. 2

**Fig. 3a**

**Fig. 3b**

1g

**Fig.4**

**Fig. 5a**

**Fig. 5b**

4a

100d/1d

4b

**Fig. 6**

100e/1e

4b

4a

**Fig. 7**

100f/1f

**Fig. 8**

1a-g

Z'

Z

24

23

21

**Fig.9**

**Fig.10a**

**Fig.10b**

Europäisches
Patentamt

European
Patent Office

Office européen
des brevets

**EUROPÄISCHER RECHERCHENBERICHT**

Nummer der Anmeldung

**EP 23 18 2252**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2016/116554 A1 (SAKELLARIOU DIMITRIOS [FR] ET AL) 28. April 2016 (2016-04-28) * Absatz [0012] – Absatz [0077] * * Abbildungen 1, 4A, 6A, 10 * ----- | 1,2,4,6, 8-18 | INV. G01R33/34 |
| X | US 6 751 847 B1 (BREY WILLIAM W [US] ET AL) 22. Juni 2004 (2004-06-22) * Spalte 6, Zeilen 6-43 * * Abbildungen 6-8 * ----- | 1,2,4,5, 8-18 | |
| X | JP 2011 062476 A (KANEKA CORP; UNIV TOHOKU) 31. März 2011 (2011-03-31) * Abbildung 12 * ----- | 1,2,4, 8-18 | |
| X | EP 1 143 257 A2 (VARIAN INC [US]) 10. Oktober 2001 (2001-10-10) * Absatz [0029] – Absatz [0031] * * Abbildungen 3b, 3c * ----- | 1,2,4,5, 8-18 | |
| A,D | SUN Y ET AL: "The tilted coil for NMR experiments", JOURNAL OF MAGNETIC RESONANCE. SERIES A, ACADEMIC PRESS, ORLANDO, FL, US, Bd. 105, Nr. 2, 1. Januar 1993 (1993-01-01), Seiten 145-150, XP002243649, ISSN: 1064-1858, DOI: 10.1006/JMRA.1993.1266 * das ganze Dokument * ----- | 1-18 | RECHERCHIERTE SACHGEBIETE (IPC) G01R |
| A,D | PRIVALOV A.F ET AL: "Coil Design for Large-Volume High-B1 Homogeneity for Solid-State NMR Applications", JOURNAL OF MAGNETIC RESONANCE. SERIES A, 1. Dezember 1996 (1996-12-01), Seiten 157-160, XP093066122, DOI: 10.1006/jmra.1996.0229 * das ganze Dokument * ----- | 1-18 | |

Der vorliegende Recherchenbericht wurde für alle Patentansprüche erstellt

| Recherchenort | Abschlußdatum der Recherche | Prüfer |
|---|---|---|
| München | 14. November 2023 | Streif, Jörg Ulrich |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.......................................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 18 2252

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-11-2023

| Im Recherchenbericht angeführtes Patentdokument | Datum der Veröffentlichung | Mitglied(er) der Patentfamilie | Datum der Veröffentlichung |
|---|---|---|---|
| US 2016116554 A1 | 28-04-2016 | EP 2979104 A1 | 03-02-2016 |
| | | FR 3003958 A1 | 03-10-2014 |
| | | US 2016116554 A1 | 28-04-2016 |
| | | WO 2014155312 A1 | 02-10-2014 |
| US 6751847 B1 | 22-06-2004 | KEINE | |
| JP 2011062476 A | 31-03-2011 | JP 5504785 B2 | 28-05-2014 |
| | | JP 2011062476 A | 31-03-2011 |
| EP 1143257 A2 | 10-10-2001 | EP 1143257 A2 | 10-10-2001 |
| | | US 6359437 B1 | 19-03-2002 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6359437 B1

**In der Beschreibung aufgeführte Nicht-Patentliteratur**

- **Y.H. SUN ; G.E. MACIEL.** *J. Magn. Reson.,* 1993, vol. 105, 145-150
- **F. PRIVALOV, S. V. DVINSKIKH, H.-M. VIETH.** *J. Magn. Reson.,* 1996, vol. 123, 157-160
- **J. MISPELTER.** Nmr Probeheads For Biophysical And Biomedical Experiments: Theoretical Principles And Practical Guidelines. World Scientific Publishing Company, 2015, 89